# EUROPEAN PATENT SPECIFICATION

(11) **EP 0 935 291 B1**
(45) Date of publication and mention of the grant of the patent: **28.01.2009**
(21) Application number: 98300894.7
(22) Date of filing: 06.02.1998
(51) Int. Cl.: H01L 29/772, H01L 29/786, H01L 27/108

(54) **Controllable solid-state device comprising a tunnel barrier structure**
Steuerbare Festkörperanordnung mit einer Tunnelbarrierestruktur
Dispositif contrôlable à l'état solide comprenant une structure à barrière tunnel

(43) Date of publication of application: 11.08.1999
(73) Proprietor: Hitachi, Ltd., Chiyoda-ku Tokyo (JP)
(72) Inventor: Mizuta, Hiroshi, Milton, Cambridge, CB4 6ZR (GB); NAKAZATO, Kazuo, Cambridge, CB2 2RP (GB); ITOH, Kiyoo, Tokyo 203 (JP); SCHIMADA, Toshikazu, Tokyo 185 (JP); TESHIMA, Tatsuya, Sagamihara, Kanagawa 228 (JP); YAMAGUCHI, Ken, Tokyo (JP)
(74) Representative: Piotrowicz, Pawel Jan Andrzej

(56) References cited:
- EP-A- 0 901 169
- US-A- 5 714 766
- PATENT ABSTRACTS OF JAPAN vol. 096, no. 008, 30 August 1996 -& JP 08 097305 A (HITACHI LTD), 12 April 1996,
- AUSINT D G ET AL: "GAAS/ALGAAS/INGAAS VERTICAL TRIPLE BARRIER SINGLE ELECTRON TRANSISTORS" JAPANESE JOURNAL OF APPLIED PHYSICS, vol. 36, no. 3B, PART 01, March 1997, pages 1667-1671, XP000703094
- NAKAGAWA T ET AL: "Thermally stimulated resonant current in AlGaAs/GaAs triple barrier diodes" APPLIED PHYSICS LETTERS, 10 AUG. 1987, USA, vol. 51, no. 6, ISSN 0003-6951, pages 445-447, XP002071001

## Description

This invention relates to a controllable conduction device for use in a memory or a transistor structure.

In JP-A-8097395 there is described a memory device which includes a memory node to which charge is written through a multiple tunnel junction from a control electrode. The multiple tunnel junction comprises alternating layers of doped polysilicon each having a thickness of 15 nm and silicon dioxide each having a thickness of 3 nm. Charge transfer through the multiple tunnel junction is controlled using Coulomb blockade.

In EP-A-0843360 (Article 54(3) EPC) there is described a memory device which includes a memory node to which charge is written through a barrier configuration from a control electrode. The stored charge affects the conductivity of a source-drain path and data is read by monitoring the conductivity of the path. The charge barrier configuration comprises a multiple tunnel barrier which may comprise alternating layers of polysilicon of 3nm thickness and layers of silicon nitride of 1nm thickness, overlying a polycrystalline layer of silicon, part of which acts as a memory node. Alternative barrier configurations are described including conductive nanometre scale conductive islands which act as a memory node, distributed in an insulating matrix. The charge barrier configuration exhibits a relatively low but wide barrier extending across the width of the barrier configuration interspersed with relatively narrow but high barriers as a result of the different material regions used in the barrier structure. The advantage of the tunnel barrier configuration is that it reduces leakage current from the memory node without degrading the reading and writing times for the memory. Different types of memory device are described. In a first type, charge carriers from a control electrode pass through the barrier configuration to the memory node in response to a voltage applied to the control electrode. In a second type of device, an additional gate is provided for the barrier configuration in order to control the transfer of charge carriers from the control electrode to the memory node.

The charge barrier configuration can also be used in a controllable conduction device such as a transistor, as described in EP-A-0892440 (Article 54(3) EPC). The barrier configuration is used to provide a conductive path between a source and drain. When switched on, charge carriers can flow between the source and drain, but when switched off, the barrier configuration inhibits charge leakage through the path. A large on/off current ratio is obtained.

In EP-A-0901169 (Article 54(3) EPC), an improved barrier structure is described for use in a transistor or a memory. The barrier structure is formed of regions of relatively conductive and non-conductive material such that in a first condition, charge carrier flow can occur by tunnelling through the structure and in a second condition the regions present a barrier configuration that inhibits charge carrier flow through the structure. An output region receives charge carriers that pass along a path through the structure, and an input region supplies charge carriers to the path so as to pass through the structure to the output region. The regions of non-conductive material are configured so as to provide an energy band profile that comprises a main barrier component and further barrier components the further barrier components being adjacent the input and output regions respectively, and the main barrier component being between the further barrier components. An example is described with reference to Figure 10 and 11 of EP-A-0901169 supra.

A controllable conduction device in accordance with the present invention is set out in claim 1. Specific embodiments are defined in the dependent claims.

In accordance with the present invention, the main barrier component has a width of 2nm or more, the further barrier components have a width of 3nm or less, the main barrier component being thicker than the further barrier components and the main and further barrier components are spaced apart by 45 nm or less and the further barrier components being separated from the input and output regions by respective regions of relatively conductive material included in the barrier structure.

In one example of the invention, the main barrier component has a width of 6nm or more, and the main and further barrier components are spaced apart by 20nm or less.

The device may include a gate for controlling charge carrier flow through the barrier structure. The gate may be a side gate.

The input region may include an electrode for supplying charge carriers to the barrier structure.

The device may be configured as a memory in which the output region comprises a memory node to store charge from the path.

Alternatively, the device may be configured as a transistor in which the input region is a source region for charge carriers arid the output region is a drain region.

Preferably, the regions of non-conductive material comprise layers of silicon nitride and the regions of relatively conductive material comprise layers of intrinsic silicon.

Collectively, the regions of the barrier structure may give rise to a dimensionally relatively wide barrier component across the width of the barrier structure with a relatively low barrier height, and the non-conductive regions giving rise to barrier components that are dimensionally relatively narrow compared with the wide barrier component but with a relatively high barrier height.

In order that the invention may be more fully understood, embodiments thereof will now be described by way of example with reference to the accompanying drawings, in which:
Figure 1a is a schematic cross section of a transistor in accordance with the invention;
Figure 1b is a schematic cross section of a memory device in accordance with the invention;
Figure 2a is a schematic energy diagram of the barrier structure in the device of Figures 1a, b under conditions of zero bias;
Figure 2b corresponds to Figure 2a under a condition of forward bias;
Figure 3a-f are schematic cross sectional views of a sequence of process steps for fabricating a memory device in accordance with the invention;
Figure 4 is a plan view of the memory device made by the process shown in Figure 3;
Figure 5 illustrates the voltage-current characteristics of one of the guard barriers shown in Figures 1a and b;
Figure 6 is a three dimensional energy band diagram of the barrier structure shown in Figures 1a, b; and
Figure 7 illustrates the relationship between the thickness of the main barrier and the spacing between the main and guard barriers, as a function of current flow through the barrier structure, in the on and off states respectively.

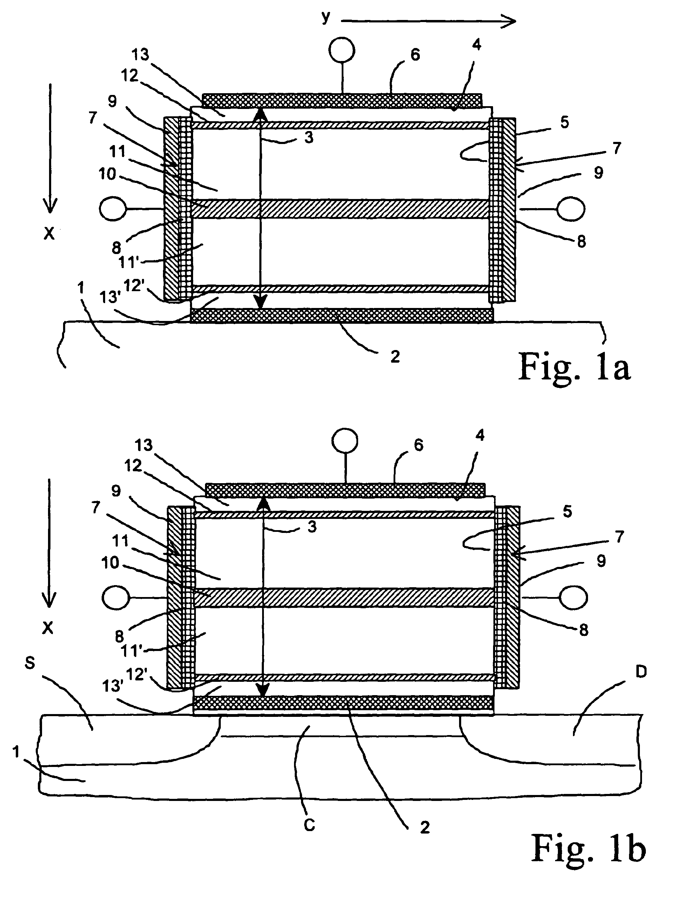

Figures 1a and 1b illustrate examples of a transistor and memory device in accordance with the invention. The transistor of Figure 1a operates in accordance with the principles of the device described in EP-A-0892440 ***supra*** and the memory device of Figure 1b operates in accordance with the principles of the device described in EP-A-0843361 ***supra***. However, both devices include an improved side gated structure which operates according to the principles described with reference to Figures 10 and 11 of EP-A-0901169 ***supra***.

The device as shown in Figures 1a and b include a substrate 1 overlaid by an output region 2, which itself is overlaid by an upstanding pillar structure 3, with a top surface 4 and a side wall 5. An input region 6 overlays the top surface 4 and a side gate 7 is formed on the side wall 5.

In the transistor device of Figure 1a, the output region 2 comprises an n-doped polysilicon layer which acts as a drain. The input region 6 comprises a conductive polysilicon layer, to provide a source for charge carriers. The multiple layer structure 3 acts as a tunnel barrier configuration which, during conduction, allows a source-drain current to flow, but when in the off-state, inhibits a leakage current along the source-drain path.

The gate 7 consists of an insulating layer of silicon dioxide 8 overlaid by a conductive polysilicon layer 9. A voltage applied to the gate thus controls the conductivity of the source-drain path.

In the memory device shown in Figure 1b, the output region 2 comprises a memory node of polysilicon which receives charge from the input electrode 6 through the multiple layer structure 3 under the control of the side gate 7.

The substrate 1 includes source and drain regions S, D disposed on opposite sides of a channel C. The conductivity of the channel C is influenced by the level of stored charge on the memory node and so the level of stored charge can be sensed by determining the conductivity of the channel C between the source S and drain D. The characteristics of these devices are described in more detail in our aforementioned applications.

The characteristics of the multiple layer structure 3 and its associated tunnel barrier configuration will now be described in more detail. The multiple layer structure 3 consists of alternate layers of relatively conducting and non-conducting material. In this example, non-conducting silicon nitride and conducting intrinsic silicon are used. The configuration consists of a main barrier layer 10 of silicon nitride, sandwiched between spacer layers 11, 11' of intrinsic silicon, and guard barriers 12, 12' of silicon nitride, are disposed between layers 13, 13' of intrinsic silicon and the layers 11, 11' respectively.

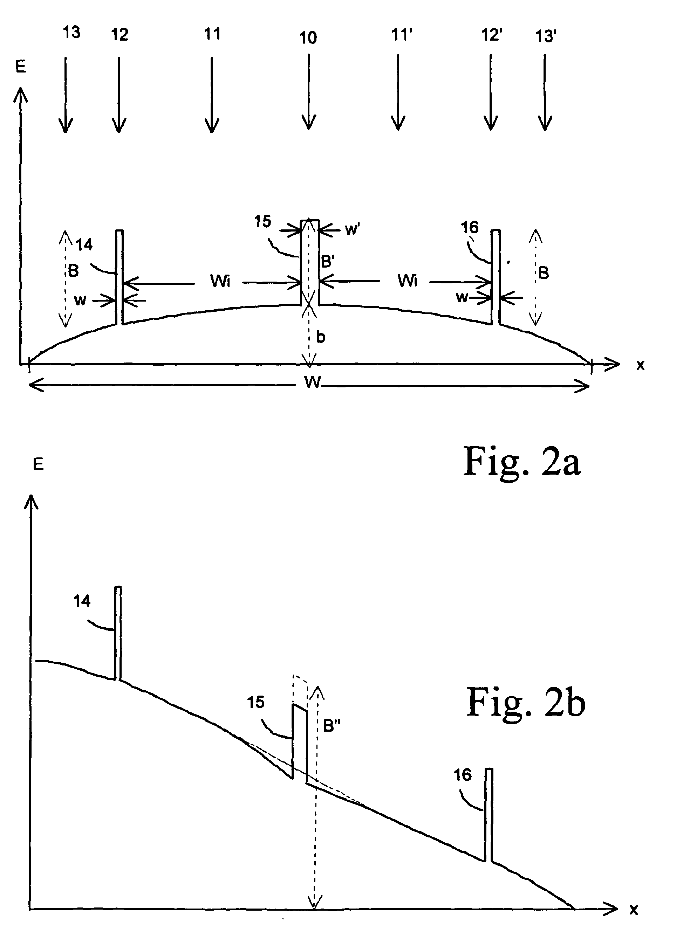

The energy band diagram of the multiple layer structure 3 is shown in Figure 2. Referring to Figure 2a, under conditions of zero bias, the multiple layer structure gives rise to a relatively wide barrier of width *W* extending across substantially the entire width of the layer structure, with a relatively low barrier height *b*. Additionally, the main and guard barrier layers 10, 12, 12' give rise to relatively narrow but high barrier components 14, 15, 16. The width of the barrier components 14, 15, 16 is a function of the thickness of the layers 10, 12, 12'. In this example, it is assumed that the guard barrier layers 12, 12' are of substantially the same thickness, giving rise to barriers of width *w*, and height B. The main barrier 15 has a height B'. The thickness of the main barrier 15 is different from the thickness of the guard barriers 14, 16, and is referenced *w'*. The main and guard barriers are spaced apart by a distance Wi, corresponding to the thickness of layers 11, 11'.

It has been found that under conditions of zero bias, the barrier structure shown in Figure 2a provides an effective barrier against charge carrier flow between the input and output regions 6, 2 as will be explained in more detail hereinafter.

Referring to Figure 2b, this shows the situation in which a bias voltage is applied to the input region 6. As a result, a potential gradient is produced between the input and output regions 6, 2 which overcomes the effect of the relatively wide barrier *W*. Electrons can then tunnel through the narrow but high barriers 14, 15 and 16 so as to pass down the potential gradient between the input and output regions 6, 2.

Furthermore, the total height of the barrier B' can be altered by the application of voltage to the side gate 7. The effect of increased voltage on the side gate is shown for the barrier 15. The total height of barrier B" is reduced from the height shown in dotted outline to the configuration shown in solid outline in Figure 2b.

When the device is used as a memory as shown in Figure 1b, after charge has tunnelled onto the memory node 2 and the bias voltages are removed, the charge is retained on the node and, as will be explained hereinafter, the retention time can be of the order of 10 years. Accordingly, the device can be operated as a fast non-volatile RAM. For the configuration of Figure 1a, the device operates as a normally-off transistor, with an extremely low leakage between the source and drain in the off state.

The effect of the guard barriers 14, 16 is to avoid massive electron redistribution around the layer 10 that gives rise to the main barrier 15, so as to achieve improved downward potential slope when voltages are applied to the gate 7 and the input electrode 6.

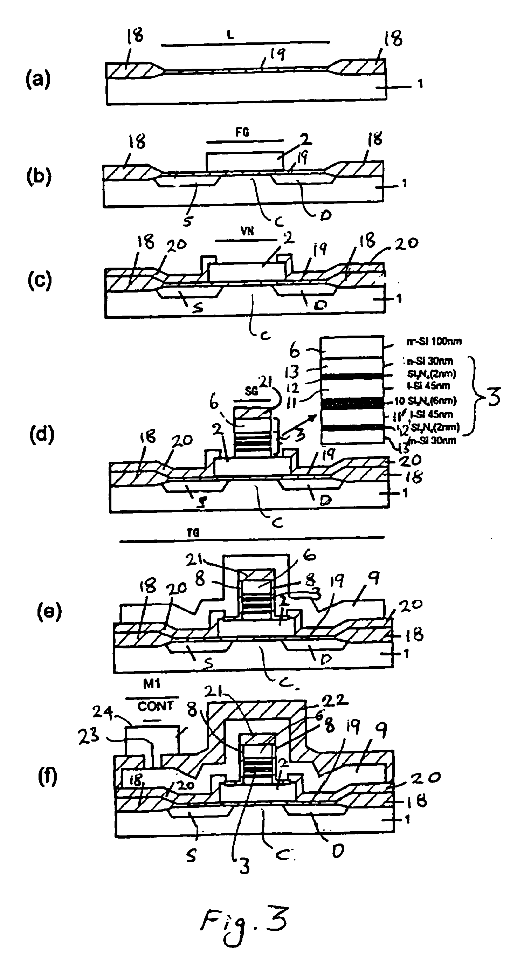

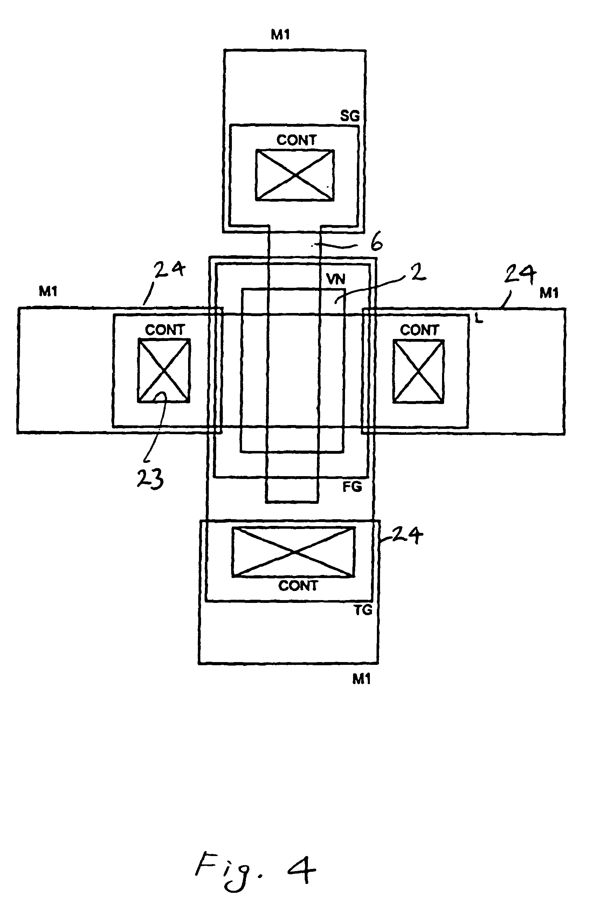

An example of a method of fabricating a memory device according to Figure 1b will now be described in more detail with reference to Figure 3. The resulting device is shown in plan view in Figure 4.

Referring to Figure 3a, the starting material is a p-type silicon wafer 1. A 400nm thickness layer 18 of SiO₂ is formed on the substrate 1 and then, using a conventional LOCOS process with an optical photomask (L), a region 19 of SiO₂, of thickness 5nm is formed in the region under the photomask.

Ion implantation is then carried out in order to form heavily doped p-type channel stopper regions (not shown) under the layer 18 in order to inhibit conduction between adjacent memory devices (not shown) formed on the same substrate.

Additionally, ion implantation is carried out to adjust the threshold voltage of the eventual channel C formed in the substrate, so as to adjust the threshold of the eventual MOS transistor S, D, C formed in the substrate 1 (see Figure 1b).

Referring to Figure 3b, a layer 2 which is used to produce the memory storage node 2, is formed on the SiO₂ layers 18, 19 and patterned by a conventional optical lithographic technique, using a photomask (FG) and dry etching. The layer 2 comprises 100nm thickness of polysilicon deposited by low pressure technical vapour deposition (LPCVD). Arsenic ions are then implanted into the layer 2 and the substrate 1 in order to form an n⁺-doped conductive layer 2 that can be used as the memory storage node, and so as to provide the source and drain regions S, D of the MOS transistor formed in the substrate 1. The arsenic ions are implanted with dosage of 5 x 10⁻¹⁵cm⁻² at an energy of the order of 25keV.

Referring to Figure 3c, the silicon oxide layer 20 is deposited on the structure, and a contact window is etched through the layer 20 by means of an optical lithographic technique, using a photomask (VN) and dry etching, in a manner known ***per se***.

Then, as shown in Figure 3d, a stack of silicon and silicon nitride layers is formed so as to form the multiple layer structure 3. In this example, the multiple layer structure 3 comprises a 30nm lightly n-doped silicon layer 13', a 2nm thickness silicon nitride layer 12', which gives rise to the first guard barrier, a 45nm thickness intrinsic silicon space layer 11', a 6nm thickness silicon nitride layer 10, which gives rise to the main barrier, together with layers 11, 12 and 13, which correspond to the layers 11', 12' and 13', so as to provide the second guard barrier 12, of 2nm thickness, spaced from the main barrier 10 by 45nm. The structure is covered by a 100nm thickness layer of n-doped silicon which forms the electrode 6.

The thin silicon nitride layers 12, 12' which give rise to the guard barriers, are grown by thermal nitridation of silicon in an atmosphere of NH₃ at a temperature of 900°C. The silicon nitride layer 10 which gives rise to the main barrier is formed by chemical vapour deposition (CVD).

Thereafter, a 50nm thickness SiO₂ layer 21 is deposited on the multiple layer structure 3. The resulting arrangement of layers 3 and 21 are then patterned by conventional optical lithographic techniques using a photomask (SG) and dry etching, so as to form an upstanding pillar structure on the memory node region 2.

Referring to Figure 3e, a 10nm thickness layer 8 of insulating SiO₂ is formed by thermal oxidation or deposition around the side walls of the pillar structure to provide an electrically insulating layer. Then, a layer 9 of boron doped silicon is deposited to a thickness of 100nm and patterned by optical lithography using a photomask (TG) and dry etching. As will be evident hereinafter, the conductive boron doped layer 9 is used as the side gate for the multiple layer structure 3, in the manner shown in Figure 1b.

Thereafter, as shown in Figure 3f, a silicon oxide layer 22 of 100nm thickness is deposited over the structure, and contact windows are etched through the oxide layer 22 by optical lithography using a photomask (CONT) and dry etching, in order to provide contact windows 23 to permit electrical connection to be made to the side gate layer 9. As shown in Figure 4, contact windows 24 to the input electrode layer 6 and the side gate layer 9 are simultaneously formed by means of this processing step.

It will be understood that in practice, many of the memory devices will be simultaneously formed in an array on the substrate 1. The source and drain regions S, D thus may run from cell to cell and external connections (not shown) are provided for them elsewhere on the substrate.

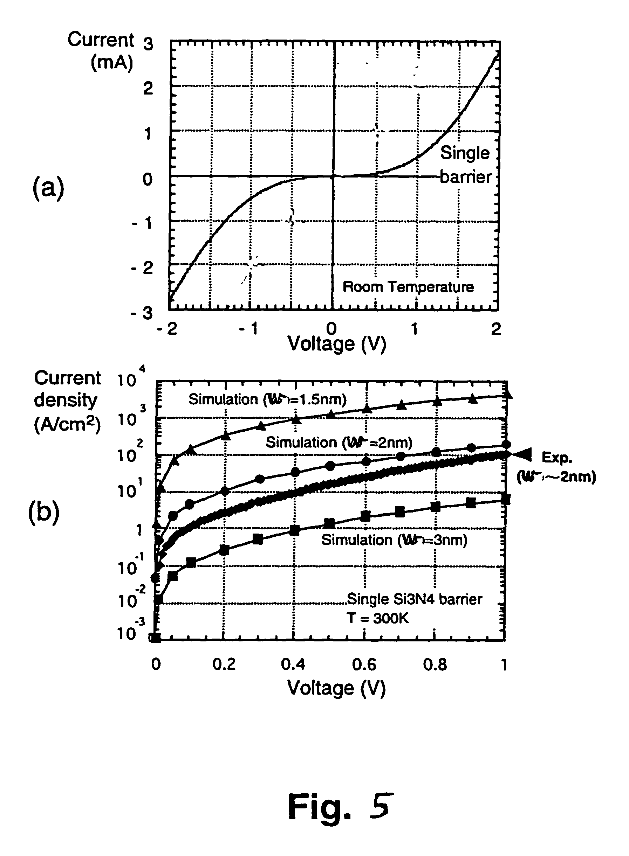

The characteristics of the main barrier 10 and the guard barriers will now be considered in more detail. Referring to Figure 5, an investigation of the characteristics of the guard barrier layers 12, 12' was carried out both by experimentation and by simulation. The voltage-current characteristics of one of the barriers 12, 12' is shown in Figure 5a and the current density achievable is shown in Figure 5b. The results in Figure 5b are derived from a junction with an area of 50µm x 50µm for a barrier thickness *w* ∼ 2nm and simulations for *w* = 1.5, 2 and 3 nm are also shown. It will be seen that a tunnel current density in excess of 10²A/cm⁻² can be obtained, which is suitable for achieving high speed write/erase operation of the device, when embodied as a memory.

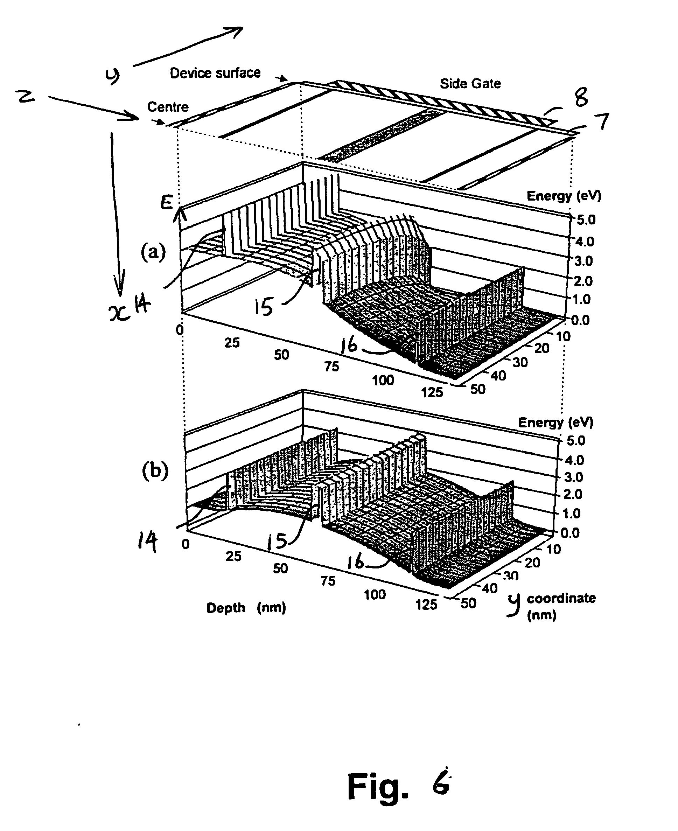

The relationship between the thickness of the main barrier layer 10, the thicknesses of the guard barriers 12, 12' and the spacing between the barriers, determined by the thickness of the layers 11, 11' will now be considered in more detail. The on/off characteristics of the layer structure 3, when embodied in a normally-off transistor are shown in Figure 6. This illustrates, as a three dimensional energy diagram, the energy band diagram through the layer structure from a centre line z, in a direction x and y also illustrated in Figure 1a. Figure 6a illustrates the energy band diagram in an on-state i.e. with current flow between the source 6 and drain 2, whereas Figure 6b illustrates the energy diagram in the off-state. In the on-state, the drain-source voltage V_{ds} = 3.0V and the voltage between the side gate 7 and the source 6 V_{gs} = 3.0V. In the off state, V_{ds} = 1.0V and V_{gs} = 0V. The lateral dimension (2y) of the layer structure 3 was 0.1 m. The thickness of the main silicon nitride barrier layer 10 was 6nm and the thickness of each of the layers 11, 11' was 45nm.

In the off-state shown in Figure 6b, both the relatively narrow barriers 14, 15, 16 of width *w* and *w'*, together with the relatively wide barrier *b* of width *W* combine together to act as a barrier to prevent the passage of electrons. The tunnelling current in an off-state was calculated to be 2.81 x 10⁻³⁴A. When used in the memory device shown in Figure 1b, this barrier configuration guarantees non-volatility with a retention time of over two years.

In the on-state shown in Figure 6, the main barrier 16 is reduced (as described with reference to Figure 2b) so as to allow charge carrier tunnelling down the potential gradient between the input and output regions 6, 2. The reduction in height of the main barrier 16 occurs to a major extent in the vicinity of the side gate 7. The resulting tunnelling current is of the order of 0.6µA. For the memory device of Figure 1b, it is estimated that the amount of charge required on the memory node 2 to obtain a voltage shift of 1.0V for the sensing transistor device S, D, C is of the order of 1700e (where e is the charge of a single electron). From this data, the charging and discharging time for the memory node 2 is estimated to be of the order 0.45n sec for the memory device according to the invention.

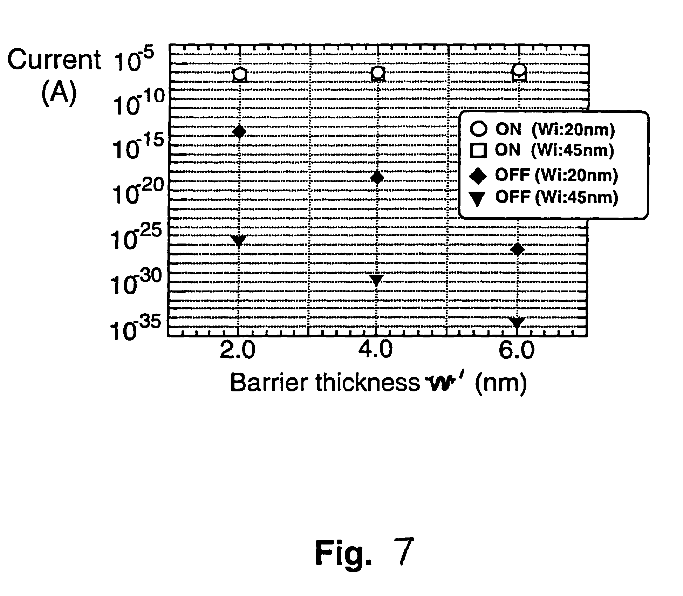

The on and off currents that result from different values of thickness *w'* of the main barrier 15, as determined by the thickness of the silicon nitride layer 10, is shown in Figure 7, for different values of thickness Wi of the spacer layers 11, 11'. It will be seen that the tunnel current in the off state is reduced by increasing the thickness of the main barrier layer 10, so as to increase the barrier thickness *w'* and the thickness Wi of the intrinsic silicon layers 11, 11'. It will be seen that the current in the on state does not vary significantly over the range of thicknesses illustrated in Figure 7 because the current in the on state is determined mainly by the current that flows through the layer structure adjacent to the side gate 7 (Figure 6). To achieve a data retention time of the order of 10 years, the tunnelling current in the off state should be smaller than 10⁻²⁵A. This means that *w'* should be greater than 6nm when Wi is 20nm or less and, *w'* should be greater than 2nm when Wi is 45nm or less. These results show that the normally-off transistor device in accordance with the invention facilitates an extremely on-off current ratio and, by optimising structural parameters, it is possible to achieve a non-volatile memory device in the form of a high-speed RAM, with a write time of less than 1.0n sec.

## Claims

1. A controllable conduction device, including a barrier structure (3) formed of regions of relatively conductive (11, 11', 13, 13') and non-conductive material (10, 12, 12') such that in a first condition, charge carrier flow can occur by tunnelling through the structure and in a second condition the regions present a barrier configuration that inhibits charge carrier flow through the structure, an output region (2) to receive charge carriers that pass along a path through the structure, and an input region (6) for supplying charge carriers to the path so as to pass through the structure to the output region, wherein the regions of non-conductive material are configured so as to provide an energy band profile that comprises a main barrier component (15) and further barrier components (14, 16), the further barrier components being adjacent the input and output regions respectively, and the main barrier component being between the further barrier components, the main barrier component having a width of 2nm or more, the further barrier components having a width of 3nm or less, the main barrier component being thicker than the further barrier components and the main and further barrier components being spaced apart by 45 nm or less and the further barrier components being separated from the input and output regions by respective regions (13, 13') of relatively conductive material included in the barrier structure.

2. A device according to claim 1 wherein the main barrier component (15) has a width of 6nm or more, and the main and further barrier components are spaced apart by 20nm or less.

3. A device according to claim 1 or 2 including a gate (7) for controlling charge carrier flow through the barrier structure (3).

4. A device according to claim 1, 2 or 3 wherein the input region (6) includes an electrode for supplying charge carriers to the barrier structure (3).

5. A device according to any preceding claim wherein the output region (2) comprises a memory node to store charge from the path.

6. A device according to any one of claims 1 to 4 wherein the input region (6) is a source region for charge carriers and the output region (2) is a drain region.

7. A device according to any preceding claim wherein the regions of non-conductive material (10, 12, 12') comprise layers of silicon nitride and the regions of relatively conductive material (11, 11', 13, 13') comprise layers of intrinsic silicon.

8. A device according to any preceding claim wherein the regions of the barrier structure (3) give rise to a dimensionally relatively wide barrier component across the width of the barrier structure(W) with a relatively low barrier height (b), and the non-conductive regions (10, 12, 12') give rise to barrier components that are dimensionally relatively narrow (w, w') compared with the wide barrier component but with a relatively high barrier height (B).

## Patentansprüche

1. Steuerbares Leitungsgerät, aufweisend eine Grenzstruktur (3), die durch Bereiche von relativ leitfähigem (11, 11', 13, 13') und nicht leitfähigem Material (10, 12, 12') so gebildet ist, dass Ladungsträgerfluss in einem ersten Zustand durch Tunneln durch die Struktur auftreten kann und dass die Bereiche in einem zweiten Zustand eine Grenzkonfiguration darstellen, die Ladungsträgerfluss durch die Struktur hemmt, einen Ausgabebereich (2) zum Empfangen von Ladungsträgern, die entlang eines Pfades durch die Struktur passieren, und einen Eingabebereich (6) zum Zuführen von Ladungsträgern zu dem Pfad, um durch die Struktur zum Ausgabebereich zu passieren, wobei die Bereiche von nicht leitfähigem Material dazu eingerichtet sind, ein Energiebandprofil bereitzustellen, das eine Hauptgrenzkomponente (15) und weitere Grenzkomponenten (14, 16) umfasst, wobei die weiteren Grenzkomponenten dem Eingabe- bzw. Ausgabebereich gegenüber liegen, und wobei die Hauptgrenzkomponente zwischen den weiteren Grenzkomponenten ist, wobei die Hauptgrenzkomponente eine Breite von 2 nm oder mehr hat, wobei die weiteren Grenzkomponenten eine Breite von 3 nm oder weniger haben, wobei die Hauptgrenzkomponente dicker als die weiteren Grenzkomponenten ist und wobei die Haupt- und weiteren Grenzkomponenten mit 45 nm oder weniger beabstandet sind und wobei die weiteren Grenzkomponenten von dem Eingabe- und Ausgabebereich durch jeweilige Bereiche (13, 13') von relativ leitfähigem Material getrennt sind, das in der Grenzstruktur enthalten ist.

2. Gerät nach Anspruch 1, wobei die Hauptgrenzkomponente (15) eine Breite von 6 nm oder mehr hat und wobei die Haupt- und weiteren Grenzkomponenten mit 20 nm oder weniger beabstandet sind.

3. Gerät nach Anspruch 1 oder 2, aufweisend ein Gate (7) zum Steuern von Ladungsträgerfluss durch die Grenzstruktur (3).

4. Gerät nach Anspruch 1, 2, oder 3, wobei der Eingabebereich (6) eine Elektrode zum Zuführen von Ladungsträgern zur Grenzstruktur (3) aufweist.

5. Gerät nach einem der vorhergehenden Ansprüche, wobei der Ausgabebereich (2) einen Speicherknoten umfasst, um Ladung aus dem Pfad zu speichern.

6. Gerät nach einem der Ansprüche 1 bis 4, wobei der Eingabebereich (6) ein Sourcebereich für Ladungsträger ist und wobei der Ausgabebereich (2) ein Drainbereich ist.

7. Gerät nach einem der vorhergehenden Ansprüche, wobei die Bereiche von nicht leitfähigem Material (10, 12, 12') Schichten von Siliziumnitrid umfassen und wobei die Bereiche von relativ leitfähigem Material (11, 11', 13, 13') Schichten von intrinsischem Silizium umfassen.

8. Gerät nach einem der vorhergehenden Ansprüche, wobei die Bereiche der Grenzstruktur (3) zu einer dimensional relativ breiten Grenzkomponente über die Breite der Grenzstruktur (W) mit einer relativ geringen Grenzhöhe (b) führen, und wobei die nicht leitfähigen Regionen (10, 12, 12') zu Grenzkomponenten führen, die verglichen mit der breiten Grenzkomponente dimensional relativ schmal (w, w') aber mit einer relativ hohen Grenzhöhe (B) sind.

## Revendications

1. Dispositif à conduction pouvant être commandée, comprenant une structure de barrière (3) formée de régions de matières relativement conductrices (11, 11', 13, 13') et non conductrices (10, 12, 12') telles que, dans une première condition, un flux de porteurs de charge puisse avoir lieu par effet tunnel à travers la structure et que, dans une seconde condition, les régions présentent une configuration de barrière qui s'oppose au flux de porteurs de charge à travers la structure, une région de sortie (2) destinée à recevoir des porteurs de charge qui parcourent un chemin à travers la structure, et une région d'entrée (6) destinée à alimenter en porteurs de charge le chemin afin de les faire passer à travers la structure jusqu'à la région de sortie, dans lequel les régions de matière non conductrice sont configurées de façon à présenter un profil de bande d'énergie qui comprend un constituant de barrière principal (15) et d'autres constituants de barrière (14, 16), les autres constituants de barrière étant adjacents aux régions d'entrée et de sortie, respectivement, et le constituant de barrière principal étant entre les autres constituants de barrière, le constituant de barrière principal ayant une largeur de 2 nm ou plus, les autres constituants de barrière ayant une largeur de 3 nm ou moins, le constituant de barrière principal étant plus épais que les autres constituants de barrière et les constituants de barrière principale et autres étant espacés de 45 nm ou moins et les autres constituants de barrière étant séparés des régions d'entrée et de sortie par des régions respectives (13, 13') de matière relativement conductrice incluses dans la structure de barrière.

2. Dispositif selon la revendication 1, dans lequel le constituant de barrière principal (15) a une largeur de 6 nm ou plus, et les constituants de barrière principale et autres sont espacés de 20 nm ou moins.

3. Dispositif selon la revendication 1 ou 2, comprenant une grille (7) destinée à commander un flux de porteurs de charge à travers la structure de barrière (3).

4. Dispositif selon la revendication 1, 2 ou 3, dans lequel la région d'entrée (6) comprend une électrode destinée à fournir des porteurs de charge à la structure de barrière (3).

5. Dispositif selon l'une quelconque des revendications précédentes, dans lequel la région de sortie (2) comporte un noeud de mémoire destiné à stocker une charge provenant du chemin.

6. Dispositif selon l'une quelconque des revendications 1 à 4, dans lequel la région d'entrée (6) est une région de source pour des porteurs de charge et la région de sortie (2) est une région de drain.

7. Dispositif selon l'une quelconque des revendications précédentes, dans lequel les régions de matière non conductrice (10, 12, 12') comprennent des couches de nitrure de silicium et les régions de matière relativement conductrice (11, 11', 13, 13') comprennent des couches de silicium intrinsèque.

8. Dispositif selon l'une quelconque des revendications précédentes, dans lequel les régions de la structure de barrière (3) donnent naissance à un constituant de barrière dimensionnellement relativement large sur la largeur de la structure de barrière (W) avec une hauteur de barrière relativement basse (b), et les régions non conductrices (10, 12, 12') donnent naissance à des constituants de barrière qui sont dimensionnellement relativement étroits (w, w') en comparaison avec le constituant de barrière large, mais avec une hauteur de barrière relativement grande (B).
